# EUROPEAN PATENT APPLICATION

(11) **EP 4 401 307 A1**
(43) Date of publication of application: **17.07.2024**
(21) Application number: 24150768.0
(22) Date of filing: 08.01.2024
(51) Int. Cl.: H03F 1/02, H03F 1/42, H03F 1/56, H03F 3/195, H03F 3/24

(54) **METHODS AND TECHNIQUES TO ACHIEVE TARGET PHASE SHIFT OVER WIDE FREQUENCY BAND IN THE INPUT OF DOHERTY POWER AMPLIFIERS**

(30) Priority: 13.01.2023 US 202363479787 P; 13.01.2023 US 202363479788 P; 13.01.2023 US 202363479790 P; 15.05.2023 US 202363502268 P; 30.06.2023 US 202363511352 P; 17.07.2023 US 202363513974 P; 20.09.2023 US 202363539384 P; 29.12.2023 US 202318400451
(71) Applicant: Qorvo US, Inc., Greensboro, NC 27409 (US)
(72) Inventor: SHAHVERDI, Amin, Richardson (US); HAJJI, Rached, Richardson (US); LANDON, Thomas, Richardson (US)
(74) Representative: D Young & Co LLP

(57) **Abstract**

This disclosure relates generally to Doherty amplifiers. In one embodiment, a Doherty amplifier includes an RF input of the Doherty amplifier for receiving a radio frequency (RF) signal, a main amplifier (104) coupled to the RF input, and an auxiliary amplifier (106) coupled to the RF input. A phase lag component (116) connected between the RF input and one of either the main amplifier (104) or the auxiliary amplifier (106) and a phase lead component (114) connected between the RF input and another one of either the main amplifier (104) or the auxiliary amplifier (106). In some embodiments, the phase lead and phase lag components (114, 116) ensure that the split signals output from the main and auxiliary amplifiers (104, 106) are recombined in phase throughout a frequency band.

## Description

### Related Applications

This application claims the benefit of provisional patent application serial number 63/539,384, filed September 20, 2023, the disclosure of which is hereby incorporated herein by reference in its entirety.

This application claims the benefit of provisional patent application serial number 63/513,974, filed July 17, 2023, and claims the benefit of provisional patent application serial number 63/511,352, filed June 30, 2023, and claims the benefit of provisional patent application serial number 63/502,268, filed May 15, 2023, and claims the benefit of provisional patent application serial number 63/479,790, filed January 13, 2023, and claims the benefit of provisional patent application serial number 63/479,788, filed January 13, 2023, and claims priority to provisional patent application serial number 63/479,787, filed January 13, 2023, the disclosures of which are hereby incorporated herein by reference in their entireties.

### Field of the Disclosure

This disclosure relates generally to Doherty amplifiers formed in integrated circuit (IC) structures.

### Background

Doherty amplifiers are popular for having high efficiency at average output power as well as maximum output power. A Doherty amplifier generally includes a main amplifier (also known as a carrier amplifier) and an auxiliary amplifier (also known as a peaking amplifier). The main and auxiliary amplifiers are biased differently, such that the main amplifier is always providing amplification to a radio frequency (RF) signal while the auxiliary amplifier only provides amplification once the RF signal reaches a particular power level. Doherty amplifiers typically show high efficiency at average power when operating with modulated signal. However, the efficiency of currently known Doherty amplifiers degrades when amplifying a wideband modulated RF signal (e.g., a 5G New Radio (NR) signal with 560MHz bandwidth).

### Summary

Particular aspects are set out in the appended independent claims. Various optional embodiments are set out in the dependent claims.

In some embodiments, a Doherty amplifier, includes: a radio frequency (RF) input of the Doherty amplifier for receiving an RF signal; a main amplifier coupled to the RF input; an auxiliary amplifier coupled to the RF input; a phase lag component connected between the RF input and one of either the main amplifier or the auxiliary amplifier; and a phase lead component connected between the RF input and another one of either the main amplifier or the auxiliary amplifier. In some embodiments, the Doherty amplifier is a non-inverting Doherty amplifier wherein: the phase lead component is connected between the RF input of the Doherty amplifier and the main amplifier; and the phase lag component is connected between the RF input of the Doherty amplifier and the auxiliary amplifier. In some embodiments, the Doherty amplifier further includes: an RF output of the Doherty amplifier for outputting the RF signal after amplification; and a quarter wave component connected between the main amplifier and the RF output of the Doherty amplifier. In some embodiments, the Doherty amplifier further includes a splitter having an input terminal, a first output terminal, and a second output terminal, wherein: the input terminal is coupled to the RF input of the Doherty amplifier; the first output terminal is coupled to an input of the main amplifier; and the second output terminal is coupled to an input of the auxiliary amplifier. In some embodiments, the Doherty amplifier further includes a hybrid coupler having a first terminal, a second terminal, a third terminal, and a fourth terminal, wherein: the first terminal is coupled to the RF input of the Doherty amplifier; the second terminal is coupled to ground; the third terminal is coupled to an input of the main amplifier; and the fourth terminal is coupled to an input of the auxiliary amplifier. In some embodiments, the phase lead component provides a first phase shift such that a phase lead within a frequency band at an input of the main amplifier is equal to +(1-α)β; and the phase lag component provides a second phase shift such that a phase lag within the frequency band at an input of the auxiliary amplifier is equal to -α(β) or -90- α(β), wherein: α is a parameter slope of a phase difference in phase between the input of the auxiliary amplifier and the input of the main amplifier throughout the frequency band; and β is a parameter that determines the phase difference in phase between the input of the main amplifier and the input of the auxiliary amplifier at a center frequency of the frequency band. In some embodiments, the frequency band is defined by a third generation partnership project (3GPP) or a federal communications commission (FCC). In some embodiments, a first phase shift and a second phase shift are set such that a maximum output power at the RF output of the Doherty amplifier, resulting from power of the main amplifier and power from the auxiliary amplifier, is between plus or minus .5dB of a target power over a frequency band. In some embodiments, the Doherty amplifier is an inverting Doherty amplifier wherein: the phase lead component is connected between the RF input of the Doherty amplifier and the auxiliary amplifier; and the phase lag component is connected between the RF input of the Doherty amplifier and the main amplifier. In some embodiments, the Doherty amplifier further includes: an RF output of the Doherty amplifier for outputting the RF signal after amplification; and a quarter wave component connected between the main amplifier and the RF output of the Doherty amplifier. In some embodiments, the Doherty amplifier further includes a splitter having an input terminal, a first output terminal, and a second output terminal, wherein: the input terminal is coupled to the RF input of the Doherty amplifier; the first output terminal is coupled to an input of the main amplifier; and the second output terminal is coupled to an input of the auxiliary amplifier. In some embodiments, the Doherty amplifier further includes a hybrid coupler having a first terminal, a second terminal, a third terminal, and a fourth terminal, wherein: the first terminal is coupled to the RF input of the Doherty amplifier; the second terminal is coupled to ground; the third terminal is coupled to an input of the main amplifier; and the fourth terminal is coupled to an input of the auxiliary amplifier. In some embodiments,: the phase lead component provides a first phase shift such that a phase lead within a frequency band at an input of the auxiliary amplifier is equal to +(1-α)β; and the phase lag component provides a second phase shift such that a phase lag within the frequency band at an input of the main amplifier is equal to -α(β) or -90- α(β), wherein: α is a parameter slope of a phase difference in phase between the input of the main amplifier and the input of the auxiliary amplifier throughout the frequency band; and β is a parameter that determines the phase difference in phase between the input of the main amplifier and the input of the auxiliary amplifier at a center frequency of the frequency band. In some embodiments, the frequency band is defined by a third generation partnership project (3GPP) or a federal communications commission (FCC). In some embodiments, a first phase shift and a second phase shift are set such that a maximum output power at the RF output of the Doherty amplifier, resulting from power of the main amplifier and power from the auxiliary amplifier, is between plus or minus .5dB of a target power over a frequency band.

In some embodiments, a Doherty amplifier, includes: a radio frequency (RF) input of the Doherty amplifier for receiving an RF signal; a main amplifier coupled to the RF input; an auxiliary amplifier coupled to the RF input; a phase lag component providing a first phase shift, the phase lag component being connected between the RF input and one of either the main amplifier or the auxiliary amplifier; a phase lead component providing a second phase shift, the phase lead component being connected between the RF input and another one of either the main amplifier or the auxiliary amplifier; and wherein the first phase shift and the second phase shift are set such that a maximum output power at an RF output of the Doherty amplifier, resulting from power of the main amplifier and power from the auxiliary amplifier, is between plus or minus .5dB of a target power over a frequency band. In some embodiments, the Doherty amplifier is a non-inverting Doherty amplifier wherein: the phase lead component is connected between the RF input of the Doherty amplifier and the main amplifier; and the phase lag component is connected between the RF input of the Doherty amplifier and the auxiliary amplifier. In some embodiments, the phase lead component provides the first phase shift such that a phase lead within the frequency band at an input of the main amplifier is equal to +(1-α)β; and the phase lag component provides the second phase shift such that a phase lag within the frequency band at an input of the auxiliary amplifier is equal to -α(β) or -90- α(β), wherein: α is a parameter slope of a phase difference in phase between the input of the auxiliary amplifier and the input of the main amplifier throughout the frequency band; and β is a parameter that determines the phase difference in phase between the input of the main amplifier and the input of the auxiliary amplifier at a center frequency of the frequency band. In some embodiments, the Doherty amplifier is an inverting Doherty amplifier wherein: the phase lead component is connected between the RF input of the Doherty amplifier and the auxiliary amplifier; and the phase lag component is connected between the RF input of the Doherty amplifier and the main amplifier. In some embodiments, the phase lead component provides the first phase shift such that a phase lead within the frequency band at an input of the auxiliary amplifier is equal to +(1-α)β; and the phase lag component provides the second phase shift such that a phase lag within the frequency band at an input of the main amplifier is equal to -α(β) or -90- α(β), wherein: α is a parameter slope of a phase difference in phase between the input of the main amplifier and the input of the auxiliary amplifier throughout the frequency band; and β is a parameter that determines the phase difference in phase between the input of the main amplifier and the input of the auxiliary amplifier at a center frequency of the frequency band.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure:
FIG. 1A is a non-inverted Doherty amplifier, in accordance with some embodiments;
FIG. 1B is an inverted Doherty amplifier 150, in accordance with some embodiments;
FIG. 2 is a plot that illustrates the phase difference between the input of a main amplifier and the input of an auxiliary amplifier as a function of frequency, in accordance with some embodiments;
FIG. 3A is another non-inverted Doherty amplifier, in accordance with some embodiments;
FIG. 3B is another inverted Doherty amplifier, in accordance with some embodiments;
FIG. 4 is a phase lead component, in accordance with some embodiments;
FIG. 5 is a phase lag component, in accordance with some embodiments;
FIG. 6A illustrates the drain efficiency of the conventional inverted Doherty at an average output power of 39dBm and drain efficiency of the inverted Doherty amplifier shown in FIG. 1B at an average output power of 39dBm, in accordance with some embodiments;
FIG. 6B illustrates the drain efficiency 602A of the conventional inverted Doherty at saturation and drain efficiency 600B of the inverted Doherty amplifier shown in FIG. 1B at saturation, in accordance with some embodiments;
FIG. 6C illustrates the output power 604A of the conventional inverted Doherty at saturation and output power 604B of the inverted Doherty amplifier shown in FIG. 1B at saturation, in accordance with some embodiments;
FIG. 7A illustrates the drain efficiency of the conventional Doherty amplifier, wherein each line represents a different frequency, in accordance with some embodiments;
FIG. 7B illustrates the gain of the conventional Doherty amplifier, wherein each line represents a different frequency, in accordance with some embodiments;
FIG. 7C illustrates the drain efficiency of the inverted Doherty amplifier shown in FIG. 1B, wherein each line represents a different frequency, in accordance with some embodiments;
FIG. 7D illustrates the gain of the inverted Doherty amplifier shown in FIG. 1B, wherein each line represents a different frequency, in accordance with some embodiments; and
FIG. 8 is a user element, in accordance with some embodiments.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

This disclosure relates generally to Doherty amplifiers. Doherty amplifiers include a main amplifier and an auxiliary amplifier. While the main amplifier is turned on throughout the amplification of a radio frequency (RF) signal, the auxiliary amplifier is turned on after a threshold.

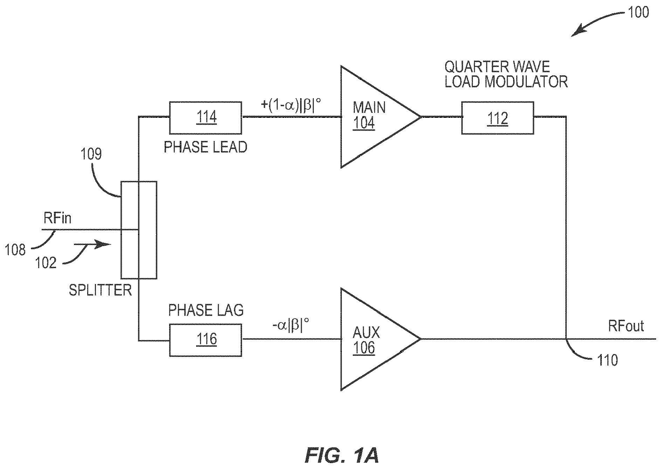

FIG. 1A is a Doherty amplifier 100, in accordance with some embodiments.

The Doherty amplifier 100 is an integrated circuit (IC) or a module amplification device. In some embodiments, the Doherty amplifier 100 is a non-inverting Doherty amplifier. The Doherty amplifier 100 is configured to amplify a radio frequency signal 102. The specific characteristics of the Doherty amplifier 100 may vary in accordance with the communication device and technological environment in which the Doherty amplifier 100 is employed and, in addition, the performance parameters relevant to the operation of the Doherty amplifier 100 for the particular application(s) of the Doherty amplifier 100 within the communication device (or prospective communication device(s)) and the technological environment (or prospective technological environment(s)). It should be noted that the Doherty amplifier 100 may be configured for operation in any suitable communication device and technological environment. Thus, the RF signal 102 may be any type of RF signal.

In some embodiments, the Doherty amplifier is particularly useful when the RF signal 102 is a modulated RF signal. The amplification techniques explained below are particularly useful so that a main amplifier 104 and an auxiliary amplifier 106 in the Doherty amplifier 100 can maintain high efficiency with a modulated RF signal over a wide frequency band.

In some embodiments, the RF signal 102 may be multiplexed using time division multiplexing (TDM), frequency division multiplexing (FDM), space division multiplexing (SDM), code division multiple access (CDMA) multiplexing, orthogonal frequency division multiple access (OFDMA) multiplexing, and/or the like.

In some embodiments, the Doherty amplifier 100 may be configured to provide amplification for the RF signal 102 if the RF signal 102 is formatted in accordance with 2G Global System for Mobile Communications (GSM) standards, 3G standards, 3G Long Term Evolution (LTE) standards, 5G standards, 5G New Radio (NR) standards, 6G standards, and/or the like. In some embodiments, the RF signal 102 is provided in a frequency range that is defined by a third generation partnership project (3GPP) or a federal communications commission (FCC). In this embodiment, the RF signal 102 may be an RF uplink signal for uplink to a base station from a mobile communication device (e.g., smartphone, tablet, laptop, etc.). The Doherty amplifier 100 may be within the mobile communication device and the mobile communication device may be using the Doherty amplifier 100 to amplify the RF signal 102 for transmission by an antenna (not shown). Alternatively, the Doherty amplifier 100 may be within the base station. Thus, the base station may be using the Doherty amplifier 100 for amplification upon reception of the RF signal 102 from the mobile communication device.

In another embodiment, the RF signal 102 may be an RF downlink signal for downlink to the mobile communication device (e.g., smartphone, tablet, laptop, etc.) from the base station. In this case, the mobile communication device may be using the Doherty amplifier 100 to amplify the RF signal 102 after reception from the base station. Alternatively, the base station may be using the Doherty amplifier 100 to amplify the RF signal 102 for transmission by an antenna (not shown) to the mobile communication device.

To amplify the RF signal 102, the Doherty amplifier 100 includes the main amplifier 104 and the auxiliary amplifier 106. While a signal level of the RF signal 102 is below a threshold level, the auxiliary amplifier 106 is deactivated and the main amplifier 104 provides all of the amplification to the RF signal 102. In some embodiments, the threshold level corresponds with an average power level of amplification. The RF signal 102 may be any type of RF signal depending on the type of communication device (e.g., smartphone, tablet, laptop, base station, etc.) in which the Doherty amplifier 100 is provided and the amplification operation being provided by the Doherty amplifier 100. The main amplifier 104 is configured to amplify the RF signal 102 in accordance with gain of the main amplifier 104. So long as the main amplifier 104 is within a linear operating range (i.e., not saturated and below a compression point), the auxiliary amplifier 106 is deactivated. In some embodiments, the main amplifier 104 is biased so as to be a class AB amplifier or a class B amplifier.

Referring again to the Doherty amplifier 100 shown in FIG. 1A, the output impedance of the auxiliary amplifier 106 is very high and the auxiliary amplifier 106 appears like an open circuit with respect to the main amplifier 104 while the main amplifier 104 is activated and the auxiliary amplifier 106 is deactivated. However, the auxiliary amplifier 106 is configured to activate in response to the signal level of the RF signal 102 reaching a threshold level (e.g., the signal level corresponding to the average power level). The Doherty amplifier 100 is configured such that the main amplifier 104 remains activated while the auxiliary amplifier 106 is activated. In some embodiments, the main amplifier 104 may be held at or near its peak power level (i.e., saturation). In general, this peak power level occurs just prior to the 3dB compression point (i.e., a knee voltage) of the main amplifier 104 and thus when the main amplifier 104 is nearly saturated.

However, it should be noted that some embodiments of the Doherty amplifier 100 may hold the main amplifier 104 at backed-off power levels while the auxiliary amplifier 106 is activated. If the Doherty amplifier 100 holds the main amplifier 104 at backed-off power levels while the auxiliary amplifier 106 is activated, a control circuit may be configured to reduce or prevent power-efficiency degradations in the Doherty amplifier 100 due to the main amplifier 104 operating at power levels backed off from the 3dB compression point. This is typically desirable for modern communication systems. In some embodiments, the auxiliary amplifier 106 is biased as a class C amplifier.

The Doherty amplifier 100 includes an RF input 108 (also referred to as an RF input node 108), a splitter 109, an RF output 110 (also referred to as an RF output node), a quarter wave component 112, and a phase lead component 114, and a phase lag component 116. The RF signal 102 is received by the Doherty amplifier 100 at the RF input 108. The RF input 108 is connected to an input terminal of the splitter 109. The input of the main amplifier 104 is connected to one of the splitter output terminals of the splitter 109. The input of the auxiliary amplifier 106 is coupled to the other splitter output terminal of the splitter 108. Both the main amplifier input of the main amplifier 104 and the auxiliary amplifier input of the auxiliary amplifier 106 are coupled to the RF input 108 through the splitter 109.

In some embodiments, the RF input 108 is a node, a pin, a terminal, a port, a contact, a conductive pillar, a trace, or any other component capable of receiving the RF signal 102. Both the main amplifier output of the main amplifier 104 and the auxiliary amplifier output of the auxiliary amplifier 106 are coupled to the RF output 110. In some embodiments, the RF input 108 is a node, a pin, a terminal, a port, a contact, a conductive pillar, a trace, or any other component capable of transmitting the RF signal 102 to a load.

The quarter wave component 112 is coupled between the main amplifier output of the main amplifier 104 and the RF output 110. The quarter wave component 112 is configured to provide a 90 degree phase shift. In some embodiments, the quarter wave component 112 is a quarter wave transmission line transformer. In some embodiments, the quarter wave component 112 is a quadrature coupler. In some embodiments, the splitter 109 and the quarter wave component 116 are, collectively, a quadrature coupler.

While the auxiliary amplifier 106 is deactivated, the main amplifier 104 is the only amplifier that provides amplification to the RF signal 102. The quarter wave component 112 provides a 90 degree phase shift to the amplified RF signal 102 at a designed frequency. However, once the auxiliary amplifier 106 is activated, the RF signal 102 is split at the RF input 108. In some embodiment, the RF input 108 is split evenly. In other embodiments, the RF signal 102 is not split evenly. At the main amplifier input and the auxiliary amplifier input, the split RF signals are out of phase. Under ideal operating conditions, split RF signals are brought back into phase and constructively combined by the quarter wave component 112.

However, the components in the Doherty amplifier 100 each have different phase shifts throughout the frequency band of the frequency band and thus without the phase lead component 114 and the phase lag component 116 and thus the split RF signal are only brought back into phase at a single frequency or at a narrow set of frequencies. The phase lead component 114 and the phase lag component 116 are provided so as that the split RF signals are brought back into phase and constructively combined on a much wider frequency range, such as a frequency band defined by 3GPP or the FCC.

The phase lead component 114 is coupled between one of the output terminals of the splitter 109 and an input of the main amplifier 104. The phase lead component 114 is configured to provide a positive phase shift such that the phase shift is equal to +(1-α)β at the input of the main amplifier 104. The phase lag component 116 is coupled between the other output terminal of the splitter and an input of the auxiliary amplifier 106. The phase lag component 116 is configured to provide a negative phase shift such that the phase shift at the input terminal at the input of the auxiliary amplifier is equal to -α(β). α is a parameter slope of a phase difference in phase between the input of the main amplifier 104 and the input of the auxiliary amplifier 106 throughout the frequency band. The parameter α is explained in further detail below. β is a parameter that determines the phase difference in phase between the input of the main amplifier and the input of the auxiliary amplifier at a center frequency of the frequency band. The parameter β is further explained below. In this embodiment, the phase shift provided by the splitter 108 at both the output terminals is negligible. As such, the phase shift provided by the phase lead component is +(1-α)β and the phase shift provided by the phase lag component 116 is -α(β).

If the main amplifier 104 and the auxiliary amplifier 106 have a fixed and constant phase response throughout the frequency band, the α is selected so that the phase shifts provided by the phase lead component 114 and the phase lag component 116 are maintained constant throughout the frequency band. However, the main amplifier 104 and the auxiliary amplifier 106 may have a frequency response that is not constant throughout the frequency range. In this case, the parameter α is selected to compensate for the phase shift provided by the main amplifier 104 and the auxiliary amplifier 106 throughout the frequency band.

In some embodiments, a phase shift of the phase lead component 114 and the phase shift of the phase lag component 116 are such that a maximum output power at the RF output of the Doherty amplifier resulting from power of the main amplifier 104 and power from the auxiliary amplifier 106 is between plus or minus .5dB of a target power over the frequency band. The target power is specified by the application of the Doherty amplifier 100. In some embodiments, the frequency band is defined by 3GPP or the FCC.

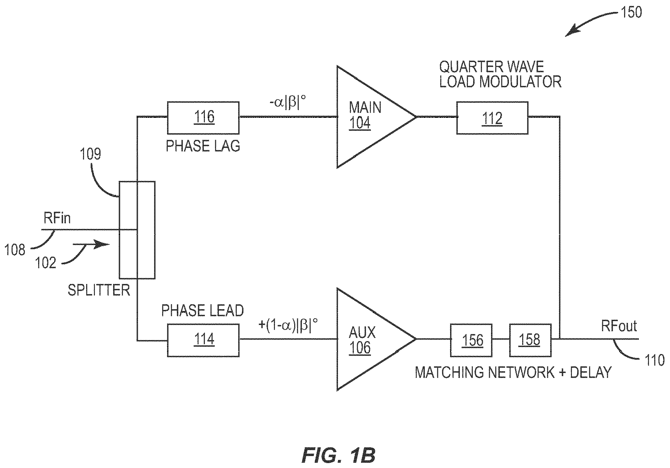

FIG. 1B is a Doherty amplifier 150, in accordance with some embodiments.

The Doherty amplifier 150 is an integrated circuit or a module amplification device. The Doherty amplifier 150 is an inverted Doherty amplifier. The Doherty amplifier 150 is configured to amplify the RF signal 102. The specific characteristics of the Doherty amplifier 150 may vary in accordance with the communication device and technological environment in which the Doherty amplifier 150 is employed and, in addition, the performance parameters relevant to the operation of the Doherty amplifier 150 for the particular application(s) of the Doherty amplifier 150 within the communication device (or prospective communication device(s)) and the technological environment (or prospective technological environment(s)). It should be noted that the Doherty amplifier 150 may be configured for operation in any suitable communication device and technological environment.

The Doherty amplifier 150 includes the RF input 108, the RF output 110, the main amplifier 104 and the auxiliary amplifier 106 described above with respect to FIG. 1A. To amplify the RF signal 102, the Doherty amplifier 150 includes the main amplifier 104 and the auxiliary amplifier 106. While a signal level of the RF signal 102 is below a threshold level, the auxiliary amplifier 106 is deactivated and the main amplifier 104 provides all of the amplification to the RF signal 102. In some embodiments, the threshold level corresponds with an average power level of amplification. The RF signal 102 may be any type of RF signal depending on the type of communication device (e.g., smartphone, tablet, laptop, base station, etc.) in which the Doherty amplifier 150 is provided and the amplification operation being provided by the Doherty amplifier 150. The main amplifier 104 is configured to amplify the RF signal 102 in accordance with the gain of the main amplifier 104. So long as the main amplifier 104 is within a linear operating range (i.e., not saturated and below a compression point), the auxiliary amplifier 106 is deactivated. In some embodiments, the main amplifier 104 is biased so as to be a class AB amplifier or a class B amplifier.

Referring again to the Doherty amplifier 150 shown in FIG. 1B, the output impedance of the auxiliary amplifier 106 is very high and the auxiliary amplifier 106 appears like an open circuit with respect to the main amplifier 104 while the main amplifier 104 is activated and the auxiliary amplifier 106 is deactivated. However, the auxiliary amplifier 106 is configured to activate in response to the signal level of the RF signal 102 reaching a threshold level (e.g., the signal level corresponding to the average power level). The Doherty amplifier 150 is configured such that the main amplifier 104 remains activated while the auxiliary amplifier 106 is activated. In some embodiments, the main amplifier 104 may be held at or near its peak power level (i.e., saturation). In general, this peak power level occurs just prior to the 3dB compression point (i.e., a knee voltage) of the main amplifier 104 and thus when the main amplifier 104 is nearly saturated.

However, it should be noted that some embodiments of the Doherty amplifier 150 may hold the main amplifier 104 at backed-off power levels while the auxiliary amplifier 106 is activated. If the Doherty amplifier 150 holds the main amplifier 104 at backed-off power levels while the auxiliary amplifier 106 is activated, a control circuit may be configured to reduce or prevent power-efficiency degradations in the Doherty amplifier 150 due to the main amplifier 104 operating at power levels backed off from the 3dB compression point. This is typically desirable for modern communication systems. In some embodiments, the auxiliary amplifier 106 is biased as a class C amplifier.

The Doherty amplifier 150 includes the phase lead component 114, the phase lag component 116, a quarter wave component 154, a matching network 156, and a delay component 158. The RF signal 102 is received by the Doherty amplifier 150 at the RF input 108. The RF input 108 is connected to a splitter 109. The input of the main amplifier 104 is connected to one of the splitter output terminals of the splitter 109. The input of the auxiliary amplifier 106 is coupled to the other splitter output terminal of the splitter 109. Both the main amplifier input of the main amplifier 104 and the auxiliary amplifier input of the auxiliary amplifier 106 are coupled to the RF input 108 through the splitter 109. In some embodiments, the RF input 108 is a node, a pin, a terminal, a port, a contact, a conductive pillar, a trace, or any other component capable of receiving the RF signal 102. Both the main amplifier output of the main amplifier 104 and the auxiliary amplifier output of the auxiliary amplifier 106 are coupled to the RF output 110. In some embodiments, the RF input 108 is a node, a pin, a terminal, a port, a contact, a conductive pillar, a trace, or any other component capable of transmitting the RF signal 102 to a load.

The quarter wave component 154 is coupled between amplifier output of the main amplifier 104 and the RF output 110. The quarter wave component 154 is configured to provide a 90 degree phase shift. In some embodiments, the quarter wave component 154 is a quarter wave transmission line transformer. In some embodiments, the quarter wave component 154 is a quadrature coupler. The matching network 156 is coupled between the output terminal of the auxiliary amplifier 106 and the delay component 158. The delay component is coupled between the matching network 156 and the RF output 110. The matching network 156 and delay component 158 are configured to match the load impedance to the impedance of the auxiliary amplifier and provide the appropriate phase shift at the RF output node 110. Under ideal operating conditions, split RF signals are brought back into phase and constructively combined by the quarter wave component 154, the matching network 156, and the delay component 158.

However, the components in the Doherty amplifier 150 each have different phase shifts throughout the frequency band of the frequency band and thus without the phase lead component 114 and the phase lag component 116 and thus the split RF signal are only brought back into phase at a single frequency or at a narrow set of frequencies. The phase lead component 114 and the phase lag component 116 are provided so as that the split RF signals are brought back into phase and constructively combined on a much wider frequency range, such as a frequency band defined by 3GPP or the FCC.

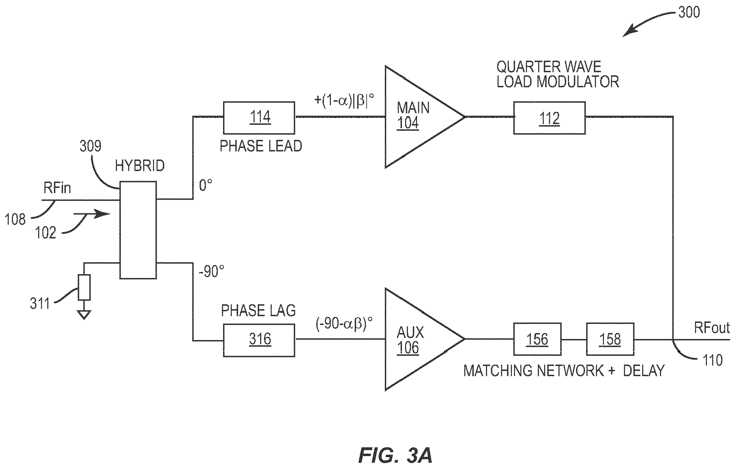

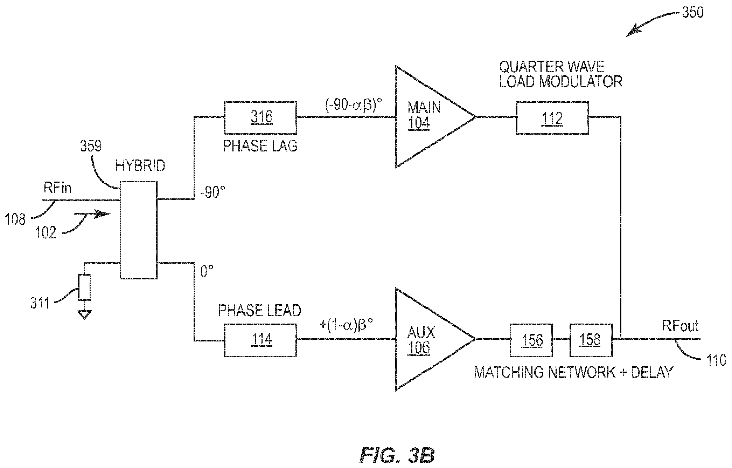

In this embodiment, the phase lead component 114 is coupled between one of the output terminals of the splitter 109 and an input of the auxiliary amplifier 106. The phase lead component 114 is configured to provide a positive phase shift such that the phase shift is equal to +(1-α)β at the input of the main amplifier 104. The phase lag component 116 is coupled between the other output terminal of the splitter and an input of the main amplifier 104. The phase lag component 116 is configured to provide a negative phase shift such that the phase shift at the input terminal at the input of the auxiliary amplifier is equal to -α(β). α is a parameter slope of a phase difference in phase between the input of the main amplifier 104 and the input of the auxiliary amplifier 106 throughout the frequency band. The parameter α is explained in further detail below. β is a parameter that determines the phase difference in phase between the input of the main amplifier 104 and the input of the auxiliary amplifier 106 at a center frequency (i.e., 3.7 GHz in FIG. 3) of the frequency band. The parameter β is further explained below. In this embodiment, the phase shift provided by the splitter 108 at both the output terminals is negligible. As such, the phase shift provided by the phase lead component 114 is +(1-α)β and the phase shift provided by the phase lag component 116 is -α(β).

If the main amplifier 104 and the auxiliary amplifier 106 have a fixed and constant phase response throughout the frequency band, the α is selected so that the phase shifts provided by the phase lead component 114 and the phase lag component 116 are maintained constant throughout the frequency band. However, the main amplifier 104 and the auxiliary amplifier 106 may have a frequency response that is not constant throughout the frequency range. In this case, the parameter α is selected to compensate for the phase shift provided by the main amplifier 104 and the auxiliary amplifier 106 throughout the frequency band. In some embodiments, a phase shift of the phase lead component 114 and the phase shift of the phase lag component 116 are such that a maximum output power at the RF output of the Doherty amplifier resulting from power of the main amplifier 104 and power from the auxiliary amplifier 106 is between plus or minus .5dB of a target power over the frequency band. The target power is specified by the application of the Doherty amplifier 100. In some embodiments, the frequency band is defined by 3GPP or the FCC.

With regards to FIG. 1A and FIG. 1B, in some embodiments, the phase lead component 114 is usually realized by a L-C-L pi-network, or a series C- shunt L network. In some embodiments, the phase lag component 116 is realized with a transmission line, a C-L-C pi-network, or a series L- shunt C network.

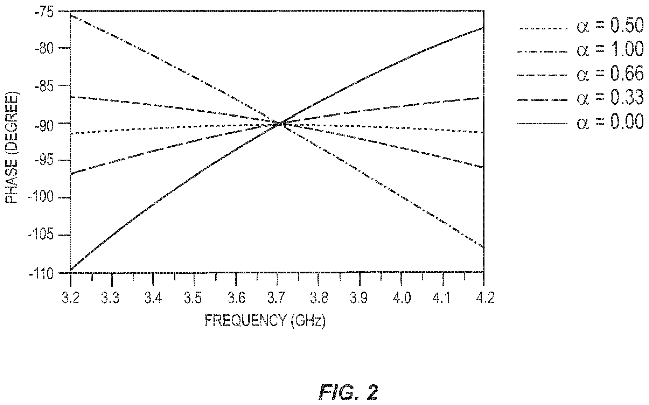

FIG. 2 is a plot that illustrates the phase difference between the input at the main amplifier 104 ( See FIG. 1B) and the input of the auxiliary amplifier 106 (See FIG. 1B) in an inverted Doherty amplifier (see FIG. 1B) as a function of frequency, in accordance with some embodiments. FIG. 2 is a plot that illustrates the phase difference between the input at the auxiliary amplifier 106 (See FIG. 1A) and the input of the main amplifier 104 (See FIG. 1A) in a non-inverted Doherty amplifier (see FIG. 1A) as a function of frequency, in accordance with some embodiments.

Several lines are shown that correspond to the phase difference wherein for each of the phase difference lines, the parameter β is selected to be 90 degrees. However, each of the lines has a different value of the parameter α. The phase difference lines correspond to the phase difference at different frequencies along a frequency band between 3.2GHz and 4.2GHz. Phase difference lines are provided for values of the parameter α at 0, .33, .5, .66. and 1. Note that at the center frequency of 3.7GHz, the value of each of the phase difference lines is 90 degrees. This is because the parameter β is equal to 90 degrees for each of the phase difference lines. Also note that for each of the values of the parameter α at 0, .33, .5, .66. and 1, the phase differences are substantially linear throughout the frequency band.

When the parameter α is equal to .5, the phase difference line is maintained at approximately 90 degrees throughout the frequency band, as shown in FIG. 2. If the main amplifier 104 (See FIG. 1A and FIG. 1B) and of the auxiliary amplifier 106 (See FIG. 1A and FIG. 1B) have a relatively fixed phase throughout the frequency band, then setting the parameter α equal to .5 result in the phase lead component 114 and the phase lag component 116 being provided so as that the split RF signals output from the main amplifier 104 and the auxiliar amplifier 106 are brought back into phase and constructively combined at the RF output 110 throughout the frequency band. However, the main amplifier 104, the auxiliary amplifier 106, the quarter wave component 154, the matching network 156 (in the Doherty amplifier 150), and/or the delay component 158 (in the Doherty amplifier 150) have phases that vary throughout the frequency band. In order to compensate for this variation, the parameter α is selected so that the split RF signals output from the main amplifier 104 and the auxiliar amplifier 106 are brought back into phase and constructively combined at the RF output 110 throughout the frequency band. In other words, the phase lead component 114 and the phase lag component 116 compensate for the variation in phase of the other components in the Doherty amplifiers 100, 150 to ensure that the split RF signals output from the main amplifier 104 and the auxiliar amplifier 106 are brought back into phase and constructively combined at the RF output 110 throughout the frequency band. This ensures that the Doherty amplifiers 100, 150 operate throughout much larger frequency bands.

Note that when the parameter α is selected to be less than .5, the phase difference lines have a positive slope. Also note that when the parameter α is selected to be greater than .5, the phase difference lines have a negative slope. Also note that while the parameter β is equal to 90 degrees in the examples shown herein, the parameter β can be equal to any other value thereby moving the value of the phase difference lines at the center frequency to higher phase values or lower phase values in accordance with a desired design.

FIG. 3A is a Doherty amplifier 300, in accordance with some embodiments.

The Doherty amplifier 300 is an IC or a module amplification device. The Doherty amplifier 300 is a non-inverting Doherty amplifier. The Doherty amplifier 300 is similar to the non-inverting Doherty amplifier 100 shown in FIG. 1A. Thus, for the sake of brevity, only the components that are different between Doherty amplifier 300 and the Doherty amplifier 100 are to be discussed while all other components are presumed to operate in the same manner.

The Doherty amplifier 300 includes a hybrid coupler 309 instead of a splitter 109 (See FIG. 1A). The RF input 108 is coupled to a first terminal of the hybrid coupler 309. A terminating impedance 311 (e.g., 50 Ohm impedance) is coupled in series between a second terminal of the hybrid coupler 309 and ground. The phase lead component 114 is coupled in series between a third terminal of the hybrid coupler 309 and an input of the main amplifier 104. As in the Doherty amplifier 100, the phase lead component 114 in FIG. 3A is configured to provide a positive phase shift such that the phase shift is equal to +(1 -α)β at the input of the main amplifier 104. Also, as in the Doherty amplifier 100, the phase lead component 114 in FIG. 3A has the phase shift equal to +(1-α)β at the input of the main amplifier 104 since the phase difference between the first terminal of the hybrid coupler 309 coupled to the RF input 108 and the third terminal of the hybrid coupler 309 coupled to the input of the main amplifier 104 is zero degrees.

A phase lag component 316 is coupled in series between a fourth terminal of the hybrid coupler 309 and an input of the auxiliary amplifier 106. As in the Doherty amplifier 100, the phase lag component 316 in FIG. 3A is configured to provide a phase shift such that the phase shift is equal to -90-α(β) at the input of the auxiliary amplifier 106. However, unlike Doherty amplifier 100 shown in FIG. 1A, the phase shift at the input of auxiliary amplifier 106 is not equal to -α(β). This is because the hybrid coupler 309 provides a negative phase shift of -90 degrees between the first terminal of the hybrid coupler 309 and the fourth terminal of the hybrid coupler 309. As such, the phase lag component 316 provides a phase shift such that the phase shift of the phase lag component 316 and the -90 degree phase shift provided by the hybrid coupler 309 in combination is equal to -90-α(β) at the input of the auxiliary amplifier 106.

In some embodiments, a phase shift of the phase lead component 114 and the phase shift of the phase lag component 316 are such that a maximum output power at the RF output 110 of the Doherty amplifier 300 resulting from power of the main amplifier 104 and power from the auxiliary amplifier 106 is between plus or minus .5dB of a target power over the frequency band. The target power is specified by the application of the Doherty amplifier 300. In some embodiments, the frequency band is defined by 3GPP or the FCC.

FIG. 3B is a Doherty amplifier 350, in accordance with some embodiments.

The Doherty amplifier 350 is an IC or a module amplification device. The Doherty amplifier 300 is a non-inverting Doherty amplifier. The Doherty amplifier 300 is similar to the inverting Doherty amplifier 150 shown in FIG. 1B. Thus, for the sake of brevity, only the components that are different between Doherty amplifier 300 and the Doherty amplifier 100 are to be discussed while all other components are presumed to operate in the same manner.

The Doherty amplifier 300 includes a hybrid coupler 359 instead of a splitter 109 (See FIG. 1B). The RF input 108 is coupled to a first terminal of the hybrid coupler 359. A terminating impedance 311 (e.g., 50 Ohm impedance) is coupled in series between a second terminal of the hybrid coupler 359 and ground. The phase lead component 114 is coupled in series between a third terminal of the hybrid coupler 359 and an input of the auxiliary amplifier 106. As in the Doherty amplifier 150, the phase lead component 114 in FIG. 3A is configured to provide a positive phase shift such that the phase shift is equal to +(1-α)β at the input of the auxiliary amplifier 106. Also, as in the Doherty amplifier 150, the phase lead component 114 in FIG. 3B has the phase shift equal to +(1-α)β at the input of the auxiliary amplifier 106 since the phase difference between the first terminal of the hybrid coupler 359 coupled to the RF input 108 and the third terminal of the hybrid coupler 359 coupled to the input of the auxiliary amplifier 106 is zero degrees.

A phase lag component 316 is coupled in series between a fourth terminal of the hybrid coupler 359 and an input of the main amplifier 104. As in the Doherty amplifier 150, the phase lag component 316 in FIG. 3B is configured to provide a phase shift such that the phase shift is equal to -90-α(β) at the input of the main amplifier 106. However, unlike Doherty amplifier 100 shown in FIG. 1B, the phase shift at the input of main amplifier 104 is not equal to -α(β) This is because the hybrid coupler 309 provides a negative phase shift of -90 degrees between the first terminal of the hybrid coupler 359 and the fourth terminal of the hybrid coupler 359. As such, the phase lag component 316 provides a phase shift such that the phase shift of the phase lag component 316 and the -90 degree phase shift provided by the hybrid coupler 359 in combination is equal to -90-α(β) at the input of the main amplifier 104.

In some embodiments, a phase shift of the phase lead component 114 and the phase shift of the phase lag component 316 are such that a maximum output power at the RF output 110 of the Doherty amplifier 350 resulting from power of the main amplifier 104 and power from the auxiliary amplifier 106 is between plus or minus .5dB of a target power over the frequency band. The target power is specified by the application of the Doherty amplifier 350. In some embodiments, the frequency band is defined by 3GPP or the FCC.

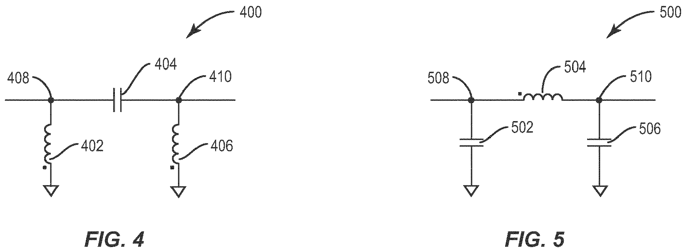

FIG. 4 is a phase lead component 400, in accordance with some embodiments.

In some embodiments, the phase lead component 114 in FIG. 1A, 1B, 3A, 3B is provided in the same manner as the phase lead component 400 in FIG. 4. The phase lead component 400 includes an inductor 402, a capacitor 404, an inductor 406, a node 408, and a node 410. The node 408 is connected to the corresponding terminal of the splitter 109 (See FIG. 1A, 1B) or the hybrid coupler 309, 359 (See FIG. 3A, 3B). The node 410 is coupled to the corresponding input of the main amplifier 104 (See FIG. 1A, 3A) or auxiliary amplifier 106 (See FIG. 1B, 3B).

The capacitor 404 is connected between the node 408 and the node 410. The inductor 402 is connected in shunt to the node 408. The inductor 406 is connected in shunt to the node 410. In this manner, the phase lead component 400 is configured to provide a positive phase shift. By selecting the inductance of the inductor 402, the capacitance of the capacitor 404, and the inductance of the inductor 406, the parameter α and the parameter β are selected.

FIG. 5 is a phase lag component 500, in accordance with some embodiments.

In some embodiments, the phase lag component 116 in FIG. 1A, 1B, is provided in the same manner as the phase lag component 500 in FIG. 5. In some embodiments, the phase lag component 316 in FIG. 3A, 3B, is provided in the same manner as the phase lag component 500 in FIG. 5. The phase lag component 500 includes a capacitor 502, an inductor 504, a capacitor 506, a node 508, and a node 510. The node 508 is connected to the corresponding terminal of the splitter 109 (See FIG. 1A, 1B) or the hybrid coupler 309, 359 (See FIG. 3A, 3B). The node 510 is coupled to the corresponding input of the auxiliary amplifier 106 (See FIG. 1A, 3A) or main amplifier 104 (See FIG. 1B, 3B).

The inductor 504 is connected between the node 508 and the node 510. The capacitor 502 is connected in shunt to the node 508. The capacitor 506 is connected in shunt to the node 510. In this manner, the phase lag component 500 is configured to provide a negative phase shift. By selecting the capacitance of the capacitor 502, the inductance of the inductor 504, and the capacitance of the capacitor 506, the parameter α and the parameter β are selected.

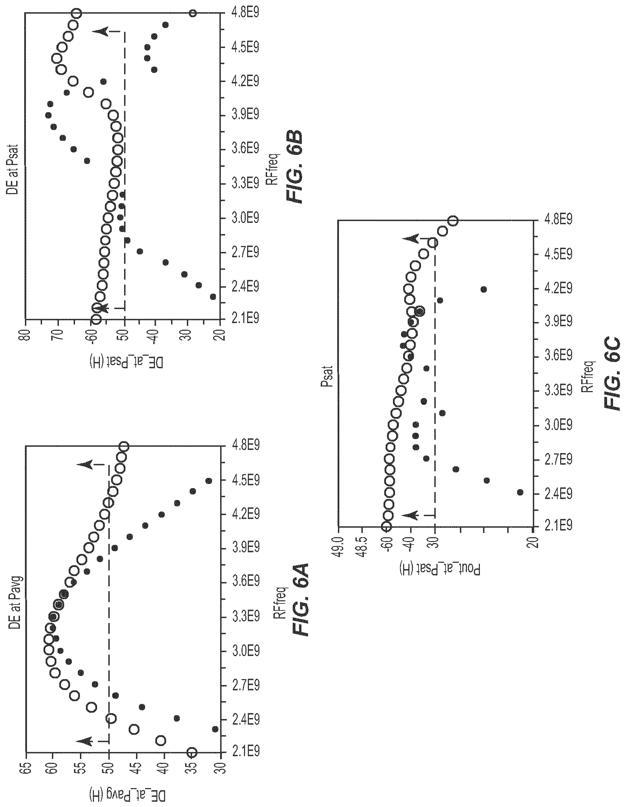

FIG. 6A, FIG. 6B, and FIG. 6C illustrate simulation results of a conventional inverted Doherty amplifier and the inverted Doherty amplifier 150 shown in FIG. 1B.

In FIG. 6A, FIG. 6B, and FIG. 6C, the parameter β was selected to be 90 degrees and the parameter α was selected to be .5 for the inverted Doherty amplifier 150.

FIG. 6A illustrates the drain efficiency 600A of the conventional inverted Doherty at an average output power of 39dBm and drain efficiency 600B of the inverted Doherty amplifier 150 at an average output power of 39dBm.

FIG. 6B illustrates the drain efficiency 602A of the conventional inverted Doherty at saturation and drain efficiency 600B of the inverted Doherty amplifier 150 at saturation.

FIG. 6C illustrates the output power 604A of the conventional inverted Doherty at saturation and output power 604B of the inverted Doherty amplifier 150 at saturation.

Considering target specification for drain efficiency and output power at saturation, the inverted Doherty amplifier 150 has a 2.5GHz bandwidth (2.1GHz - 4.6GHz) whereas conventional inverted Doherty amplifier has less than 1.3GHz bandwidth (2.8GHz - 4.1 GHz).

Considering target specification for drain efficiency at average output power, inverted Doherty amplifier 150 has 2.0GHz bandwidth (2.4GHz - 4.4GHz) whereas conventional inverted Doherty amplifier has less than 900MHz bandwidth (2.7GHz - 3.8GHz).

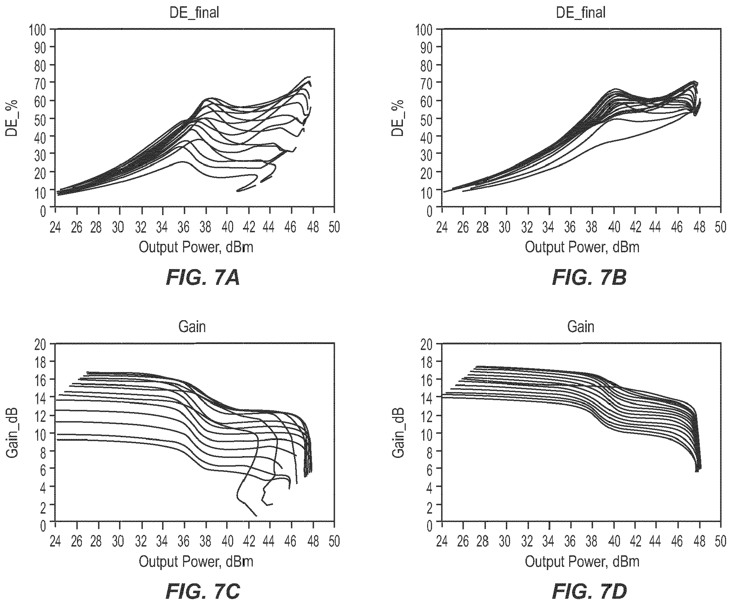

FIG. 7A and FIG. 7C illustrate simulation result for a conventional Doherty amplifier.

FIG. 7B and FIG. 7D illustrate simulation results for the inverted Doherty amplifier 150 shown in FIG. 1B.

FIG. 7A illustrates the drain efficiency of the conventional Doherty amplifier wherein each line represents a different frequency.

FIG. 7C illustrates the gain of the conventional Doherty amplifier wherein each line represents a different frequency.

FIG. 7B illustrates the drain efficiency of the inverted Doherty amplifier 150 shown in FIG. 1B wherein each line represents a different frequency.

FIG. 7D illustrates the gain of the inverted Doherty amplifier 150 shown in FIG. 1B wherein each line represents a different frequency.

More specifically, the different frequencies are frequencies from 2.1GHz to 4.8GHz in 200MHz steps. Over bandwidth of 2.7GHz, the inverted Doherty amplifier 150 shows much better performance in drain efficiency and gain (much less dispersion) at average output power, saturated output power and output power that the conventional inverted Doherty amplifier. Furthermore, the inverted Doherty amplifier 150 shows less dispersion in output power at saturation.

The simulation results in FIG. 6A-7D clearly show that the inverted Doherty amplifier 150 can improve the operating bandwidth of an inverted Doherty amplifier significantly at saturation and backed-off output power.

Meeting minimum output power at saturation is important for a Doherty amplifier as digital pre distortion (DPD) requires enough peak power to linearize the Doherty amplifier. So, less dispersion in output power at saturation significantly improves the linearized efficiency over wider frequency band.

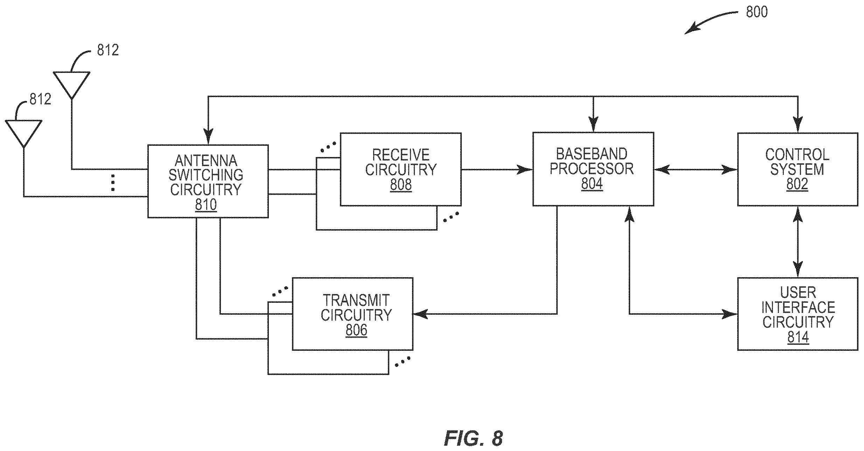

With reference to FIG. 8, the concepts described above may be implemented in various types of user elements 800, such as mobile terminals, smart watches, tablets, computers, navigation devices, access points, and like wireless communication devices that support wireless communications, such as cellular, wireless local area network (WLAN), Bluetooth, and near field communications.

The user element 800 will generally include a control system 802, a baseband processor 804, transmit circuitry 806, receive circuitry 808, antenna switching circuitry 810, multiple antennas 812, and user interface circuitry 814. In a non-limiting example, the control system 802 may be a field-programmable gate array (FPGA) or an application-specific integrated circuit (ASIC). In this regard, the control system 802 may include at least a microprocessor(s), an embedded memory circuit(s), and a communication bus interface(s). The receive circuitry 808 receives radio frequency signals via the antennas 812 and through the antenna switching circuitry 810 from one or more base stations. A low noise amplifier and a filter cooperate to amplify and remove broadband interference from the received signal for processing. Downconversion and digitization circuitry (not shown) will then downconvert the filtered, received signal to an intermediate or baseband frequency signal, which is then digitized into one or more digital streams using analog-to-digital converter(s) (ADC(s)).

In some embodiments, the Doherty amplifier 100 of FIG. 1A, the Doherty amplifier 150 of FIG. 1B, the Doherty amplifier 300 of FIG. 3A, and the Doherty amplifier 350 of FIG. 3B are implemented in the user element 800 and, in particular, in the receive circuitry 808 and/or the transmit circuitry 806.

The baseband processor 804 processes the digitized received signal to extract the information or data bits conveyed in the received signal. This processing typically comprises demodulation, decoding, and error correction operations, as will be discussed in greater detail below. The baseband processor 804 is generally implemented in one or more digital signal processors (DSPs) and ASICs.

For transmission, the baseband processor 804 receives digitized data, which may represent voice, data, or control information, from the control system 802, which it encodes for transmission. The encoded data is output to the transmit circuitry 806, where a digital-to-analog converter(s) (DAC) converts the digitally encoded data into an analog signal and a modulator modulates the analog signal onto a carrier signal that is at a desired transmit frequency or frequencies. A power amplifier will amplify the modulated carrier signal to a level appropriate for transmission and deliver the modulated carrier signal to the antennas 812 through the antenna switching circuitry 810. The multiple antennas 812 and the replicated transmit and receive circuitries 806, 808 may provide spatial diversity. Modulation and processing details will be understood by those skilled in the art.

Therefore, from one perspective, there have been described approaches for Doherty amplifiers. In one embodiment, a Doherty amplifier includes an RF input of the Doherty amplifier for receiving a radio frequency (RF) signal, a main amplifier coupled to the RF input, and an auxiliary amplifier coupled to the RF input. A phase lag component connected between the RF input and one of either the main amplifier or the auxiliary amplifier and a phase lead component connected between the RF input and another one of either the main amplifier or the auxiliary amplifier. In some embodiments, the phase lead and phase lag components ensure that the split signals output from the main and auxiliary amplifier are recombined in phase throughout a frequency band.

Further examples are set out in the following numbered clauses.

Clause 1. A Doherty amplifier, comprising: a radio frequency (RF) input of the Doherty amplifier for receiving an RF signal; a main amplifier coupled to the RF input; an auxiliary amplifier coupled to the RF input; a phase lag component connected between the RF input and one of either the main amplifier or the auxiliary amplifier; and a phase lead component connected between the RF input and an other one of either the main amplifier or the auxiliary amplifier.

Clause 2. The Doherty amplifier of clause 1, wherein the Doherty amplifier is a non-inverting Doherty amplifier wherein: the phase lead component is connected between the RF input of the Doherty amplifier and the main amplifier; and the phase lag component is connected between the RF input of the Doherty amplifier and the auxiliary amplifier.

Clause 3. The Doherty amplifier of clause 2, further comprising: an RF output of the Doherty amplifier for outputting the RF signal after amplification; and a quarter wave component connected between the main amplifier and the RF output of the Doherty amplifier.

Clause 4. The Doherty amplifier of clause 3, further comprising a splitter having an input terminal, a first output terminal, and a second output terminal, wherein: the input terminal is coupled to the RF input of the Doherty amplifier; the first output terminal is coupled to an input of the main amplifier; and the second output terminal is coupled to an input of the auxiliary amplifier.

Clause 5. The Doherty amplifier of clause 3 or 4, further comprising a hybrid coupler having a first terminal, a second terminal, a third terminal, and a fourth terminal, wherein: the first terminal is coupled to the RF input of the Doherty amplifier; the second terminal is coupled to ground; the third terminal is coupled to an input of the main amplifier; and the fourth terminal is coupled to an input of the auxiliary amplifier.

Clause 6. The Doherty amplifier of clause 3, 4 or 5, wherein: the phase lead component provides a first phase shift such that a phase lead within a frequency band at an input of the main amplifier is equal to +(1-α)β; and the phase lag component provides a second phase shift such that a phase lag within the frequency band at an input of the auxiliary amplifier is equal to -α(β) or -90- α(β), wherein: α is a parameter slope of a phase difference in phase between the input of the auxiliary amplifier and the input of the main amplifier throughout the frequency band; and β is a parameter that determines the phase difference in phase between the input of the main amplifier and the input of the auxiliary amplifier at a center frequency of the frequency band.

Clause 7. The Doherty amplifier of clause 6, wherein the frequency band is defined by a third generation partnership project (3GPP) or a federal communications commission (FCC).

Clause 8. The Doherty amplifier of any of clauses 3 to 7, wherein a first phase shift and a second phase shift are set such that a maximum output power at the RF output of the Doherty amplifier, resulting from power of the main amplifier and power from the auxiliary amplifier, is between plus or minus .5dB of a target power over a frequency band.

Clause 9. The Doherty amplifier of any of clauses 1 to 8, wherein the Doherty amplifier is an inverting Doherty amplifier wherein: the phase lead component is connected between the RF input of the Doherty amplifier and the auxiliary amplifier; and the phase lag component is connected between the RF input of the Doherty amplifier and the main amplifier.

Clause 10. The Doherty amplifier of clause 9, further comprising: an RF output of the Doherty amplifier for outputting the RF signal after amplification; and a quarter wave component connected between the main amplifier and the RF output of the Doherty amplifier.

Clause 11. The Doherty amplifier of clause 10, further comprising a splitter having an input terminal, a first output terminal, and a second output terminal, wherein: the input terminal is coupled to the RF input of the Doherty amplifier; the first output terminal is coupled to an input of the main amplifier; and the second output terminal is coupled to an input of the auxiliary amplifier.

Clause 12. The Doherty amplifier of clause 10 or 11, further comprising a hybrid coupler having a first terminal, a second terminal, a third terminal, and a fourth terminal, wherein: the first terminal is coupled to the RF input of the Doherty amplifier; the second terminal is coupled to ground; the third terminal is coupled to an input of the main amplifier; and the fourth terminal is coupled to an input of the auxiliary amplifier.

Clause 13. The Doherty amplifier of clause 10, 11 or 12, wherein: the phase lead component provides a first phase shift such that a phase lead within a frequency band at an input of the auxiliary amplifier is equal to +(1-α)β; and the phase lag component provides a second phase shift such that a phase lag within the frequency band at an input of the main amplifier is equal to -α(β) or -90- α(β), wherein: α is a parameter slope of a phase difference in phase between the input of the main amplifier and the input of the auxiliary amplifier throughout the frequency band; and β is a parameter that determines the phase difference in phase between the input of the main amplifier and the input of the auxiliary amplifier at a center frequency of the frequency band.

Clause 14. The Doherty amplifier of clause 13, wherein the frequency band is defined by a third generation partnership project (3GPP) or a federal communications commission (FCC).

Clause 15. The Doherty amplifier of any of clauses 10 to 14, wherein a first phase shift and a second phase shift are set such that a maximum output power at the RF output of the Doherty amplifier, resulting from power of the main amplifier and power from the auxiliary amplifier, is between plus or minus .5dB of a target power over a frequency band.

Clause 16. A Doherty amplifier, comprising: a radio frequency (RF) input of the Doherty amplifier for receiving an RF signal; a main amplifier coupled to the RF input; an auxiliary amplifier coupled to the RF input; a phase lag component providing a first phase shift, the phase lag component being connected between the RF input and one of either the main amplifier or the auxiliary amplifier; a phase lead component providing a second phase shift, the phase lead component being connected between the RF input and an other one of either the main amplifier or the auxiliary amplifier; and wherein the first phase shift and the second phase shift are set such that a maximum output power at an RF output of the Doherty amplifier, resulting from power of the main amplifier and power from the auxiliary amplifier, is between plus or minus .5dB of a target power over a frequency band.

Clause 17. The Doherty amplifier of clause 16, wherein the Doherty amplifier is a non-inverting Doherty amplifier wherein: the phase lead component is connected between the RF input of the Doherty amplifier and the main amplifier; and the phase lag component is connected between the RF input of the Doherty amplifier and the auxiliary amplifier.

Clause 18. The Doherty amplifier of clause 17, wherein: the phase lead component provides the first phase shift such that a phase lead within the frequency band at an input of the main amplifier is equal to +(1-α)β; and the phase lag component provides the second phase shift such that a phase lag within the frequency band at an input of the auxiliary amplifier is equal to -α(β) or -90- α(β), wherein: α is a parameter slope of a phase difference in phase between the input of the auxiliary amplifier and the input of the main amplifier throughout the frequency band; and β is a parameter that determines the phase difference in phase between the input of the main amplifier and the input of the auxiliary amplifier at a center frequency of the frequency band.

Clause 19. The Doherty amplifier of any of clauses 16 to 18, wherein the Doherty amplifier is an inverting Doherty amplifier wherein: the phase lead component is connected between the RF input of the Doherty amplifier and the auxiliary amplifier; and the phase lag component is connected between the RF input of the Doherty amplifier and the main amplifier.

Clause 20. The Doherty amplifier of clause 19, wherein: the phase lead component provides the first phase shift such that a phase lead within the frequency band at an input of the auxiliary amplifier is equal to +(1-α)β; and the phase lag component provides the second phase shift such that a phase lag within the frequency band at an input of the main amplifier is equal to -α(β) or -90- α(β), wherein: α is a parameter slope of a phase difference in phase between the input of the main amplifier and the input of the auxiliary amplifier throughout the frequency band; and β is a parameter that determines the phase difference in phase between the input of the main amplifier and the input of the auxiliary amplifier at a center frequency of the frequency band.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

## Claims

1. A Doherty amplifier, comprising:
a radio frequency (RF) input of the Doherty amplifier for receiving an RF signal;
a main amplifier coupled to the RF input;
an auxiliary amplifier coupled to the RF input;
a phase lag component connected between the RF input and one of either the main amplifier or the auxiliary amplifier; and
a phase lead component connected between the RF input and an other one of either the main amplifier or the auxiliary amplifier.

2. The Doherty amplifier of claim 1, wherein the Doherty amplifier is a non-inverting Doherty amplifier wherein:
the phase lead component is connected between the RF input of the Doherty amplifier and the main amplifier; and
the phase lag component is connected between the RF input of the Doherty amplifier and the auxiliary amplifier.

3. The Doherty amplifier of claim 2, further comprising:
an RF output of the Doherty amplifier for outputting the RF signal after amplification; and
a quarter wave component connected between the main amplifier and the RF output of the Doherty amplifier.

4. The Doherty amplifier of claim 3, further comprising a splitter having an input terminal, a first output terminal, and a second output terminal, wherein:
the input terminal is coupled to the RF input of the Doherty amplifier;
the first output terminal is coupled to an input of the main amplifier; and
the second output terminal is coupled to an input of the auxiliary amplifier.

5. The Doherty amplifier of claim 3 or 4, further comprising a hybrid coupler having a first terminal, a second terminal, a third terminal, and a fourth terminal, wherein:
the first terminal is coupled to the RF input of the Doherty amplifier;
the second terminal is coupled to ground;
the third terminal is coupled to an input of the main amplifier; and
the fourth terminal is coupled to an input of the auxiliary amplifier.

6. The Doherty amplifier of claim 3, 4 or 5, wherein:
the phase lead component provides a first phase shift such that a phase lead within a frequency band at an input of the main amplifier is equal to +(1-α)β; and
the phase lag component provides a second phase shift such that a phase lag within the frequency band at an input of the auxiliary amplifier is equal to -α(β) or -90-α(β), wherein:
α is a parameter slope of a phase difference in phase between the input of the auxiliary amplifier and the input of the main amplifier throughout the frequency band; and
β is a parameter that determines the phase difference in phase between the input of the main amplifier and the input of the auxiliary amplifier at a center frequency of the frequency band.

7. The Doherty amplifier of claim 6, wherein the frequency band is defined by a third generation partnership project (3GPP) or a federal communications commission (FCC).

8. The Doherty amplifier of any of claims 3 to 7, wherein a first phase shift and a second phase shift are set such that a maximum output power at the RF output of the Doherty amplifier, resulting from power of the main amplifier and power from the auxiliary amplifier, is between plus or minus .5dB of a target power over a frequency band.

9. The Doherty amplifier of claim 1, wherein the Doherty amplifier is an inverting Doherty amplifier wherein:
the phase lead component is connected between the RF input of the Doherty amplifier and the auxiliary amplifier; and
the phase lag component is connected between the RF input of the Doherty amplifier and the main amplifier.

10. The Doherty amplifier of claim 9, further comprising:
an RF output of the Doherty amplifier for outputting the RF signal after amplification; and
a quarter wave component connected between the main amplifier and the RF output of the Doherty amplifier.

11. The Doherty amplifier of claim 10, further comprising a splitter having an input terminal, a first output terminal, and a second output terminal, wherein:
the input terminal is coupled to the RF input of the Doherty amplifier;
the first output terminal is coupled to an input of the main amplifier; and
the second output terminal is coupled to an input of the auxiliary amplifier.

12. The Doherty amplifier of claim 10 or 11, further comprising a hybrid coupler having a first terminal, a second terminal, a third terminal, and a fourth terminal, wherein:
the first terminal is coupled to the RF input of the Doherty amplifier;
the second terminal is coupled to ground;
the third terminal is coupled to an input of the main amplifier; and
the fourth terminal is coupled to an input of the auxiliary amplifier.

13. The Doherty amplifier of claim 10, 11 or 12, wherein:
the phase lead component provides a first phase shift such that a phase lead within a frequency band at an input of the auxiliary amplifier is equal to +(1-α)β; and
the phase lag component provides a second phase shift such that a phase lag within the frequency band at an input of the main amplifier is equal to -α(β) or -90- α(β), wherein:
α is a parameter slope of a phase difference in phase between the input of the main amplifier and the input of the auxiliary amplifier throughout the frequency band; and
β is a parameter that determines the phase difference in phase between the input of the main amplifier and the input of the auxiliary amplifier at a center frequency of the frequency band.

14. The Doherty amplifier of claim 13, wherein the frequency band is defined by a third generation partnership project (3GPP) or a federal communications commission (FCC).

15. The Doherty amplifier of any of claims 10 to 14, wherein a first phase shift and a second phase shift are set such that a maximum output power at the RF output of the Doherty amplifier, resulting from power of the main amplifier and power from the auxiliary amplifier, is between plus or minus .5dB of a target power over a frequency band.
